# EUROPEAN PATENT APPLICATION

(11) **EP 4 539 126 A1**
(43) Date of publication of application: **16.04.2025**
(21) Application number: 23867106.9
(22) Date of filing: 18.07.2023
(51) Int. Cl.: H01L 29/78, H01L 21/336, H01L 29/06, H01L 27/07

(54) **POWER MOSFET AND MANUFACTURING METHOD THEREFOR**

(30) Priority: 20.09.2022 CN 202211144941
(71) Applicant: CHINA RESOURCES MICROELECTRONICS (CHONGQING) CO., LTD, Sha Ping Ba District Chongqing 401331 (CN)
(72) Inventor: LI, Ping, Wuxi, Jiangsu 214028 (CN); MA, Rongyao, Wuxi, Jiangsu 214028 (CN)
(74) Representative: Canzler & Bergmeier Patentanwälte Partnerschaft mbB
(86) International application number: PCT/CN2023/107982
(87) International publication number: WO 2024/060811

(57) **Abstract**

The present invention provides a power MOSFET and a manufacturing method therefor. The power MOSFET comprises a semiconductor structure, gate structures, source trench structures, a body region, source regions, contact regions, a barrier layer, a source, and a drain; the semiconductor layer comprises a substrate, a drift region, and a current transport layer; the gate structures are embedded in the current transport layer; each source trench structure is located between two adjacent gate structures and an upper trench is provided above the source trench structure; the body region is located on the upper surface layer of the current transport layer, and the bottoms of the upper trenches expose the body region; the source regions and the contact regions are located on the upper surface layer of the body region and are adjacent to each other; the barrier layer is located at the bottoms of the upper trenches and covers the body region; the source is in electrical contact with the barrier layer and the source trench structures, and the drain is in electrical contact with the substrate. According to the present invention, a source trench structure and an upper trench which is located above the source trench structure and exposes a body region are arranged between every two adjacent gate structures, and a barrier layer is arranged at the bottoms of the upper trenches, thereby reducing the forward conduction loss of a device, and improving the reverse current conduction capability of the device.

## Description

### FIELD OF THE INVENTION

The present invention belongs to the field of manufacturing of semiconductor integrated circuits, and relates to a power MOSFET and a preparation method for the power MOSFET.

### BACKGROUND OF THE INVENTION

Silicon carbide metal oxide semiconductor field effect transistors (SiC MOSFETs) have gained much attention due to their characteristics such as low conduction loss, fast switching speed, low switching loss, strong irradiation resistance, and good stability at high temperature. Consequently, they have become the next generation of power semiconductor devices. As a result, power conversion systems using SiC power devices offer higher conversion efficiency, smaller package size and weight, and lower system cost. In a power conversion system, it is necessary to reversely connect a fast recovery diode in parallel outside a power device as a freewheeling diode. However, the external diode will undoubtedly increase the size of the system and introduce additional parasitic inductance. In addition, due to the relatively large forbidden bandwidth of the SiC material, a PN junction body diode also exhibits a relatively large turn-on voltage (close to 3 V at room temperature). Compared to a body diode of a silicon-based power device having a turn-on voltage of 0.7 V, the use of an MOSFET body diode as a freewheeling diode results in a relatively large conduction loss. Moreover, due to basal plane dislocations of SiC crystals, during bipolar operation, the compounding of electrons and holes will cause a stacking fault to spread from a basal plane dislocation, thus increasing the on-resistance of a device and reducing the reliability of the device. Therefore, an SiC parasitic body diode is unsuitable for use as a freewheeling diode in SiC MOSFETs.

Currently, a junction barrier diode or a Schottky barrier diode is usually integrated into an SiC MOSFET to conduct reverse current, leveraging their low turn-on voltage. However, when the device is in an off state, these diodes suffer from relatively large electric leakage, especially at high temperatures, which seriously affects device reliability. Alternatively, a hetero-junction diode can be integrated into an SiC MOSFET to suppress an SiC body diode while maintaining low off-state leakage current, although fabricating a hetero-junction inside the device increases process complexity and costs. While the solution in which a built-in metal oxide semiconductor (MOS) channel diode is integrated in an SiC MOSFET does not significantly increase the off-state electric leakage and process cost of the device, achieving a lower turn-on voltage for the integrated MOS channel diode typically requires reducing the gate oxide layer thickness on one side of the MOS channel or using a lower-doped N-type layer, which also affects the reliability of the device.

Therefore, there is an urgent need to develop a power SiC MOSFET integrated with a body diode that combines high reliability and a low turn-on voltage.

### SUMMARY OF THE INVENTION

The present invention provides a power MOSFET and a preparation method for the power MOSFET, which solves the issues of high turn-on voltage and poor reliability in integrated body diodes in existing power MOSFET technologies.

The present disclosed power MOSFET comprises a semiconductor structure, gate structures, a source trench structure, a body region of a second conductivity type, source regions of a first conductivity type, contact regions of the second conductivity type, a barrier layer, a source, and a drain.

The semiconductor structure comprises a substrate of the first conductivity type and an epitaxial layer of the first conductivity type that are stacked in sequence, and the epitaxial layer comprises a drift region of the first conductivity type and a current transport layer of the first conductivity type that are stacked in sequence.

The gate structures are provided at intervals and embedded in the current transport layer.

The source trench structure is located between two adjacent gate structures. Each of side walls of the source trench structure is spaced apart from a side wall of a corresponding gate structure by a preset distance, an upper trench of a preset depth is provided above the source trench structure, and each of side walls of each upper trench protrudes from one of the side walls of the source trench structure in a direction towards the corresponding gate structures.

The body region is located on an upper surface layer of the current transport layer between each of the gate structures and the source trench structure, and the body region is exposed from a bottom of the upper trench.

The source regions and the contact regions are both located on an upper surface layer of the body region, one of the source regions and the correspond one of the contact regions located between the gate structure and the upper trench are adjacent to each other, and a side wall of said source region away from said contact region is adjacent to the side wall of the corresponding gate structure.

The barrier layer is located at the bottom of the upper trench and covers an exposed surface of the body region at the bottom of the upper trench. The barrier layer, the body region, the source trench structure, and the current transport layer form an MOS channel diode.

The source is electrically connected to the barrier layer, the source regions, the contact regions and the source trench structure. The drain is electrically connected to the substrate.

Optionally, each of the gate structures comprises a gate trench, a first dielectric layer and a gate conductive layer, the first dielectric layer is located on inner walls and a bottom face of the gate trench and wraps the gate conductive layer. The source trench structure comprises a source trench, a second dielectric layer and a source conductive layer, the second dielectric layer is located on inner walls and a bottom face of the source trench and wraps side walls and a bottom face of the source conductive layer.

Optionally, electric field shielding layers of the second conductivity type are provided in the current transport layer directly under the gate structures and the source trench structure. A lower surface of each of the electric field shielding layers is spaced apart from a bottom face of the current transport layer by a preset distance, and an upper surface of each of the electric field shielding layers is in contact with a lower surface of the correspond one of the gate structures and the source trench structure. Two adjacent electric field shielding layers are arranged spaced apart from each other.

Optionally, a doping concentration of the electric field shielding layers is greater than a doping concentration of the current transport layer.

Optionally, a length of a conductive channel of the MOS channel diode is adjusted through the depth of the upper trench.

Optionally, the barrier layer comprises one of a doped layer of the first conductivity type and a metal barrier contact layer.

Optionally, the barrier layer is the metal barrier contact layer, and a bottom face of the upper trench is lower than lower surfaces of the contact regions.

Optionally, the barrier layer covers an exposed surface of the source trench structure at the bottom of the upper trench.

Optionally, the metal barrier contact layer is not electrically connected to the source trench structure.

Optionally, the barrier layer is the doped layer of the first conductivity type, a lower surface of the barrier layer is lower than lower surfaces of the contact regions and is spaced apart from a bottom face of the body region by a preset distance, and each of side walls of the barrier layer is connected to the correspond one of the side walls of the source trench structure.

Optionally, a doping concentration of the barrier layer is higher than a doping concentration of the current transport layer.

The present disclosed preparation method for the power MOSFET comprises the following steps:
providing a semiconductor layer, wherein the semiconductor layer comprises a substrate of a first conductivity type and an epitaxial layer of the first conductivity type, and the epitaxial layer comprises a drift region of the first conductivity type and a current transport layer of the first conductivity type that are stacked in sequence;
forming a body region of a second conductivity type having a preset thickness on an upper surface layer of the current transport layer, and forming source regions of the first conductivity type and contact regions of the second conductivity type on an upper surface layer of the body region, wherein the source regions and the contact regions are alternately arranged, and a side wall of each of the source regions and a side wall of the correspond one of the contact regions are connected to each other;
forming gate structures and a source trench structure in the current transport layer, wherein the gate structures and the source trench structure are alternately arranged at a preset distance, the gate structures penetrate the source regions and the body region, and the source trench structure penetrates the body region and the contact regions;
etching the source trench structure to obtain an upper trench located above the source trench structure, wherein each of side walls of the upper trench protrudes from one of side walls of the source trench structure in a direction towards the corresponding gate structure, and the body region is exposed from a bottom of the upper trench;
forming a barrier layer at the bottom of the upper trench, wherein the barrier layer covers an exposed surface of the body region at the bottom of the upper trench, and the barrier layer, the body region, the source trench structure and the current transport layer form an MOS channel diode; and
forming a source electrically connected to the barrier layer, the source regions, the contact regions and the source trench structure, and forming a drain electrically connected to the substrate.

Optionally, each of the gate structures comprises a gate trench, a first dielectric layer and a gate conductive layer, and the first dielectric layer is located on inner walls and a bottom face of the gate trench and wraps the gate conductive layer. The source trench structure comprises a source trench, a second dielectric layer and a source conductive layer, and the second dielectric layer is located on inner walls and a bottom face of the source trench and wraps side walls and a bottom face of the source conductive layer.

Optionally, after forming the gate trench and the source trench and before forming the first dielectric layer and the second dielectric layer, the preparation method further comprises forming electric field shielding layers of the second conductivity type in the current transport layer directly under bottom faces of the gate trench and the source trench.

Optionally, the barrier layer comprises one of a doped layer of the first conductivity type and a metal barrier contact layer.

As described above, for the present disclosed power MOSFET and its preparation method, the source trench structure is located between the two adjacent gate structures, the upper trench is located above the source trench structure, and each of the side walls of the upper trench extends in a direction towards the corresponding gate structure to a preset distance away from the correspond one of the side walls of the source trench structure. Moreover, the barrier layer is formed at the bottom of the upper trench and covers the exposed surface of the body region at the bottom of the upper trench. The distance between the lower surface of the barrier layer and the bottom face of the body region is reduced by adjusting the depth of the upper trench, so as to reduce the length of the conductive channel in the structure of the MOS diode formed by the barrier layer, the body region and the source trench structure. Due to the drain-induced barrier lowering effect, the barrier for electrons to pass through the body region of the device and into the barrier layer is lowered with the decrease in length of the conductive channel, which in turn reduces the turn-on voltage of the diode and reduces the conduction loss of the device. When the device is reversely turned on, the source electrically connected to the source trench structure is connected to a high voltage, causing the conductive channel of the MOS channel diode in the body region to be opened , and resulting in the reverse current in the device being transported through the conductive channel in the MOS channel diode, thereby reducing the reverse current flowing through the body region 15, suppressing the turn-on of a body diode in the device, and eliminating bipolar degradation. In addition, the process of forming the source trench, the second dielectric layer and the conductive layer is compatible with the process of forming the gate structure, thus no complicated process is needed, and the preparation process is simple and has high industrial utilization value.

### BRIEF DESCRIPTION OF DRAWINGS

FIG. 1 shows a schematic diagram of one cross-sectional structure of a power MOSFET in the present invention.
FIG. 2 shows a schematic diagram of another cross-sectional structure of the power MOSFET in the present invention.
FIG. 3 shows variation curves of the barrier height of an MOS channel diode in the power MOSFET shown in FIG. 1 for several different channel lengths.
FIG. 4 shows a process flowchart of a preparation method for a power MOSFET in the present invention.
FIG. 5 shows a schematic diagram of a cross-sectional structure of a semiconductor structure in the preparation method for a power MOSFET in the present invention.
FIG. 6 shows a schematic diagram of a cross-sectional structure of the power MOSFET after the formation of source regions and contact regions in the preparation method of the present invention.
FIG. 7 shows a schematic diagram of a cross-sectional structure of the power MOSFET after the formation of electric field shielding layers in the preparation method of the present invention.
FIG. 8 shows a schematic diagram of a cross-sectional structure of the power MOSFET after the formation of gate structures in the preparation method of the present invention.
FIG. 9 shows a schematic diagram of one cross-sectional structure of the power MOSFET after the formation of a barrier layer in the preparation method of the present invention.
FIG. 10 shows a schematic diagram of another cross-sectional structure of the power MOSFET after the formation of the barrier layer in the preparation method of the present invention.

### Reference numerals

- 1: Semiconductor structure
- 11: Substrate
- 12: Epitaxial layer
- 121: Drift region
- 122: Current transport layer
- 13: Gate structure
- 131: Gate trench
- 132: First dielectric layer
- 133: Gate conductive layer
- 14: Source trench structure
- 141: Source trench
- 142: Second dielectric layer
- 143: Source conductive layer
- 15: Body region
- 151: Source region
- 152: Contact region
- 16: Barrier layer
- 161: Doped layer of first conductivity type
- 162: Metal barrier contact layer
- 17: Upper trench
- 18: Electric field shielding layer
- 2: Source
- 3: Drain

### DETAILED DESCRIPTION OF THE INVENTION

The embodiments of the present invention will be described hereinafter with special specific examples, and other advantages and effects of the present invention will be readily apparent to a person skilled in the art from the content disclosed in this specification. The present invention may also be implemented or applied in various other particular embodiments, and the details in this specification may be modified or altered in various ways on the basis of different viewpoints and applications without departing from the spirit of the present invention.

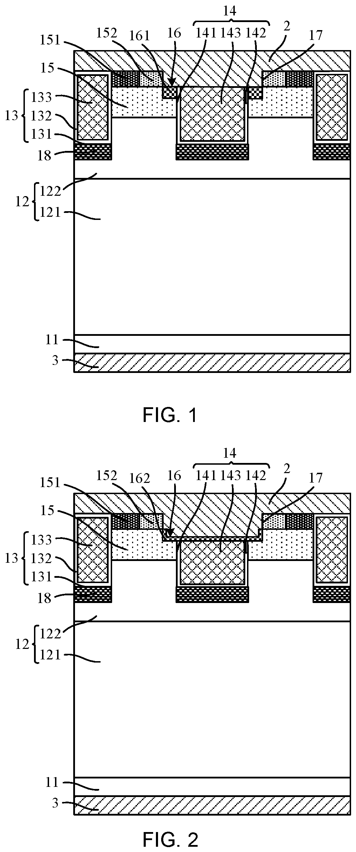

Please refer to FIG. 1 to FIG. 10. It is to be noted that the illustrations provided in the embodiments only illustrate the basic concept of the present invention in a schematic manner, and therefore the illustrations show only the components related to the present invention instead of being drawn in accordance with the numbers, shapes and sizes of components in actual implementation, the type, number and proportion of each component in actual implementation may be arbitrarily changed, and the layout pattern of the components may also be more complicated.

### Embodiment 1

The present embodiment provides a power MOSFET, as shown in FIGS. 1 and 2, which are a schematic diagram of one cross-sectional structure of the power MOSFET and a schematic diagram of another cross-sectional structure of the power MOSFET, respectively. The power MOSFET comprises a semiconductor structure 1, gate structures 13, a source trench structure 14, a body region 15 of a second conductivity type, source regions 151 of a first conductivity type, contact regions 152 of the second conductivity type, a barrier layer 16, a source 2, and a drain 3. The semiconductor structure 1 comprises a substrate 11 of the first conductivity type and an epitaxial layer 12 of the first conductivity type that are stacked in sequence, the epitaxial layer 12 comprises a drift region 121 of the first conductivity type and a current transport layer 122 of the first conductivity type that are stacked in sequence. The plurality of gate structures 13 are arranged at intervals and embedded in the current transport layer 122. The source trench structure 14 is located between two adjacent gate structures 13, each of side walls of the source trench structure 14 is spaced apart from a side wall of a corresponding gate structure 13 by a preset distance, an upper trench 17 of a preset depth is provided above the source trench structure 14, and each of side walls of the upper trench 17 protrudes from one of the side walls of the source trench structure 14 in a direction towards the corresponding gate structures 13. The body region 15 is located on an upper surface layer of the current transport layer 122 between each of the gate structures 13 and the source trench structure 14. The body region 15 is exposed from a bottom of the upper trench17. The plurality of source regions 151 and the plurality of contact regions 152 are both located on an upper surface layer of the body region 15, one of the source regions 151 and the correspond one of the contact regions 152 that are located between the gate structure 13 and the upper trench 17 are adjacent to each other, and a side wall of said source region 151 away from said contact region 152 is adjacent to the side wall of the corresponding gate structure 13. The barrier layer 16 is located at the bottom of the upper trench 17 and covers an exposed surface of the body region 15 at the bottom of the upper trench 17. The barrier layer 16, together with the body region 15, the source trench structure 14 and the current transport layer 122, forms an MOS channel diode. The source 2 is electrically connected to the barrier layer 16, the source regions 151, the contact regions 152 and the source trench structure 14, and the drain 3 is electrically connected to the substrate 11.

Specifically, the first conductivity type can be either N-type or P-type, while the second conductivity type is the opposite, being either P-type or N-type respectively. In the present embodiment, the first conductivity type is N-type, and the second conductivity type is P-type.

Specifically, the material of the substrate 11 comprises silicon carbide, silicon germanium, silicon, or other suitable semiconductor materials. In the present embodiment, the material of the substrate 11 is silicon carbide.

Specifically, the material of the epitaxial layer 12 comprises silicon carbide, silicon germanium, silicon, or other suitable semiconductor materials. In the present embodiment, the material of the epitaxial layer 12 is silicon carbide.

As an example, each of the gate structures 13 comprises a gate trench 131, a first dielectric layer 132, and a gate conductive layer 133, and the first dielectric layer 132 is located on inner walls and a bottom face of the gate trench 131 and wraps the gate conductive layer 133.

Specifically, in the case where the performance of the device is guaranteed, the depth and opening size of the gate trench 131 may be set according to the actual situation, where the depth refers to the distance from the bottom face of the gate trench 131 to an upper surface of the epitaxial layer 12.

Specifically, the first dielectric layer 132 comprises a gate dielectric layer (not shown) and an interlayer dielectric layer (not shown) which is located above the gate trench 131. In the case where the performance of the device is guaranteed, the thickness of the gate dielectric layer and the thickness of the interlayer dielectric layer may be set according to the actual situation. In the present embodiment, the gate dielectric layer has a thickness of 50 nm, and the voltage electrically connected to the gate conductive layer 133 is lower than the voltage of the source 2 in the power device, causing the thickness of the gate dielectric layer to be smaller than the thickness of the interlayer dielectric layer, thereby avoiding device breakdown and guaranteeing the performance of the device.

Specifically, the material of the gate dielectric layer comprises silicon oxide, silicon nitride, or other suitable dielectric materials; and the material of the interlayer dielectric layer comprises silicon oxide, silicon nitride, or other suitable dielectric materials.

Specifically, the material of the gate conductive layer 133 comprises polycrystalline silicon or other suitable semiconductor materials.

As an example, the source trench structure 14 comprises a source trench 141, a second dielectric layer 142, and a source conductive layer 143. The second dielectric layer 142 is located on inner walls and a bottom face of the source trench 141 and wraps side walls and a bottom face of the source conductive layer 143.

Specifically, in the case where the performance of the device is guaranteed, the depth and opening size of the source trench 141 may be set according to the actual situation, where the depth refers to the distance from the bottom face of the source trench 141 to the upper surface of the epitaxial layer 12.

Specifically, in the case where the performance of the device is guaranteed, the thickness of the second dielectric layer 142 may be set according to the actual situation. In the present embodiment, the second dielectric layer 142 has a thickness of 50 nm.

Specifically, the material of the second dielectric layer 142 comprises silicon oxide, silicon nitride, or other suitable dielectric materials.

Specifically, the material of the source conductive layer 143 comprises polycrystalline silicon or other suitable semiconductor materials.

As an example, electric field shielding layers 18 of the second conductivity type are provided in the current transport layer 122 directly under the gate structures 13 and the source trench structure 14. A lower surface of each of the electric field shielding layers 18 is spaced apart from a bottom face of the current transport layer 122 by a preset distance, and an upper surface of each of the electric field shielding layers 18 is in contact with a lower surface of the correspond one of the gate structures 13 and the source trench structure 14. Two adjacent electric field shielding layers 18 are arranged spaced apart from each other. That is, the upper surface of the electric field shielding layer 18 located directly under one gate structure 13 is in contact with the lower surface of said gate structure 13, and the upper surface of the electric field shielding layer 18 located directly under the source trench structure 14 is in contact with the lower surface of the source trench structure 14.

Specifically, each of the electric field shielding layers 18 is configured to reduce the electric field strength in the first dielectric layer 131 at the bottom of the gate structure 13 and the electric field strength in the second dielectric layer 142 at the bottom of the source trench structure 14, so as to protect the first dielectric layer 132 and the second dielectric layer 142.

Specifically, in the case where the performance of the device is guaranteed, the size and thickness of the electric field shielding layers 18 may be set according to the actual situation, where the thickness refers to the distance from the lower surface to the upper surface of the electric field shielding layer 18. In the present embodiment, the electric field shielding layers 18 have a thickness of 0.4 µm.

Specifically, the doping concentration of the electric field shielding layers 18 is greater than the doping concentration of the current transport layer 122, and in the case where the performance of the device is guaranteed and the doping concentration of the electric field shielding layers 18 remains higher than the doping concentration of the current transport layer 122, the doping concentration of the electric field shielding layers 18 may be set according to the actual situation. In the present embodiment, the electric field shielding layers 18 have a doping concentration of 1.0 × 1019 cm-3.

Specifically, in the case where the performance of the device is guaranteed, the thickness and size of the body region 15 may be set according to the actual situation, and the doping concentration of the body region 15 may be set according to the actual situation. In the present embodiment, the body region 15 has a thickness of 0.7 µm and a doping concentration of 1.4 × 1017 cm-3.

Specifically, in the case where the performance of the device is guaranteed, the size and thickness of the source regions 151 may be set according to the actual situation, where the thickness refers to the distance between an upper surface and a lower surface of the source regions 151. In the present embodiment, the source regions 151 have a thickness of 0.2 µm.

Specifically, in the case where the performance of the device is guaranteed and the source regions 151 form an ohmic contact with the source 2, the doping concentration of the source regions 151 may be set according to the actual situation. In the present embodiment, the source regions 151 have a doping concentration of 1.0 × 1019 cm-3.

Specifically, in the case where the performance of the device is guaranteed, the size and thickness of the contact regions 152 may be set according to the actual situation, where the thickness refers to the distance between an upper surface and a lower surface of the contact regions 152. In the present embodiment, the contact regions 152 have a thickness of 0.2 µm.

Specifically, in the case where the performance of the device is guaranteed and the contact regions 152 form an ohmic contact with the source 2, the doping concentration of the contact regions 152 may be set according to the actual situation. In the present embodiment, the contact regions 152 have a doping concentration of 1.0 × 1019 cm-3.

Specifically, the provision of the upper trench 17 is used for reducing a length of a conductive channel of the MOS channel diode in the device.

As an example, the depth of the upper trench 17, ranging from a bottom face of the upper trench to the upper surface of the epitaxial layer, is used to adjust the length of the conductive channel of the MOS channel diode.

Specifically, the MOS channel diode consists of the barrier layer 16, the body region 15, the source trench structure 14 and the current transport layer 122. The length of the conductive channel of the MOS channel diode is defined by the distance between the bottom face of the upper trench 17 and a bottom face of the body region 15, and this distance can be adjusted through the depth of the upper trench 17, thereby adjusting the length of the conductive channel of the MOS channel diode.

Specifically, in the case where the performance of the device is guaranteed, the thickness of the upper trench 17 may be set according to the actual situation.

As an example, the barrier layer 16 comprises one of a doped layer 161 of the first conductivity type and a metal barrier contact layer 162, and may also be of other suitable barrier structures.

Specifically, a barrier is formed using the contact between the barrier layer 16 and the body region 15, and then the MOS channel diode structure consisting of the barrier layer 16, the body region 15, the source trench structure 14 and the current transport layer 122 is formed inside the device.

As an example, the barrier layer 16 is the metal barrier contact layer 162, and a bottom face of the upper trench 17 is lower than lower surfaces of the contact regions 152, so as to reduce the length of the conductive channel of the MOS channel diode. The barrier height of the MOS channel diode is lowered by using the drain-induced barrier lowering effect, thereby reducing the turn-on voltage of the MOS channel diode and reducing the conduction loss of the device.

Specifically, in the case where the performance of the device is guaranteed, the thickness of the metal barrier contact layer 162 may be set according to the actual situation, where the thickness refers to the distance between an upper surface of the metal barrier contact layer 162 and a contact face of the metal barrier contact layer 162 and the body region 15.

Specifically, when the MOS channel diode has a low enough turn-on voltage, the distance between an upper surface of the barrier layer 16 and the bottom face of the body region 15 may be set according to the actual situation.

Specifically, when the metal barrier contact layer 162 forms a Schottky contact with the body region 15, the material of the metal barrier contact layer 162 may be selected according to the actual situation.

As an example, the barrier layer 16 covers an exposed surface of the source trench structure 14 at the bottom of the upper trench 17.

Specifically, the barrier layer 16 is the metal barrier contact layer 162, the barrier layer 16 covers an upper surface of the source trench structure 14 to electrically connect the source 2 to the source conductive layer 143, and then the source 2 is used to control the opening of the conductive channel in the MOS channel diode in the device, that is, the opening of the conductive channel in the body region 15 in contact with the side walls of the source trench structure 14, and at the same time, the manufacturing process steps of the device can be reduced and the manufacturing cost can be reduced.

Specifically, the metal barrier contact layer 162 may also not be electrically connected to the source trench structure 14, and the source 2 is directly electrically connected to the source conductive layer 143 in the source trench structure 14, which can reduce the resistance value of the electrical connection between the source 2 and the source conductive layer 143.

As an example, the barrier layer 16 is the doped layer 161 of the first conductivity type, a lower surface of the barrier layer 16 is lower than lower surfaces of the contact regions 152 and is spaced a preset distance apart from the bottom face of the body region 15, and each of side walls of the barrier layer 16 is adjacent to the correspond one of the side walls of the source trench structure 14.

Specifically, when the lower surface of the barrier layer 16 is lower than the lower surfaces of the contact regions 152 and the barrier layer 16 covers the exposed surface of the body region 15 at the bottom of the upper trench 17, the position of the upper surface of the barrier layer 16 may be set according to the actual situation.

Specifically, in the case where the performance of the device is guaranteed, the thickness and size of the doped layer 161 of the first conductivity type may be set according to the actual situation. In the present embodiment, the thickness and width of the doped layer 161 of the first conductivity type are both 0.2 µm, where the width refers to the distance between two side walls of the doped layer 161 of the first conductivity type close to the source trench structure 14 and the correspond one of the gate structures 13, respectively.

As an example, the doping concentration of the barrier layer 16 is higher than the doping concentration of the current transport layer 122, i.e., the doping concentration of the doped layer 161 of the first conductivity type is higher than the doping concentration of the current transport layer 122. In the present embodiment, the doped layer 161 of the first conductivity type has a doping concentration of 1.0 × 1019 cm-3.

Specifically, the doped layer 161 of the first conductivity type forms an ohmic contact with the source 2 to reduce the contact resistance of the MOS channel diode in the device.

Specifically, in the case where the performance of the device is guaranteed and the doped layer 161 of the first conductivity type forms an ohmic contact with the source 2, the doping concentration of the doped layer 161 of the first conductivity type may be set according to the actual situation.

Specifically, the material of the source 2 comprises one of titanium, titanium nitride, silver, gold, copper, aluminum and tungsten, and may also be other suitable conductive materials.

Specifically, the material of the drain 3 comprises one of titanium, titanium nitride, silver, gold, copper, aluminum and tungsten, and may also be other suitable conductive materials.

Specifically, due to the provision of the upper trench 17, the length of the conductive channel of the MOS channel diode in the device is reduced. According to the drain-induced barrier lowering effect, as the length of the conductive channel decreases, the height of the barrier for electrons to pass through the body region and into the barrier layer 16 decreases, which in turn reduces the turn-on voltage of the MOS channel diode in the device. When the device is reversely turned on, the source 2 electrically connected to the source trench structure 14 is connected to a high voltage, causing the conductive channel of the MOS channel diode in the body region 15 to be opened and resulting in the reverse current in the device being transported through the conductive channel in the MOS channel diode, thereby reducing the current flowing through the body region 15. Moreover, as a result of the reduction of the current flowing through the body region 15, the turn-on of the body diode in the device is suppressed, thereby eliminating the phenomenon of bipolar degradation, and improving the reliability of the device while improving the reverse conduction capability of the device.

Specifically, due to the provision of the MOS channel diode and the electric field shielding layers 18, the reverse conduction capability of the device is improved, and the device also has a greater breakdown voltage and lower gate charge characteristic without degrading other electrical properties of the device.

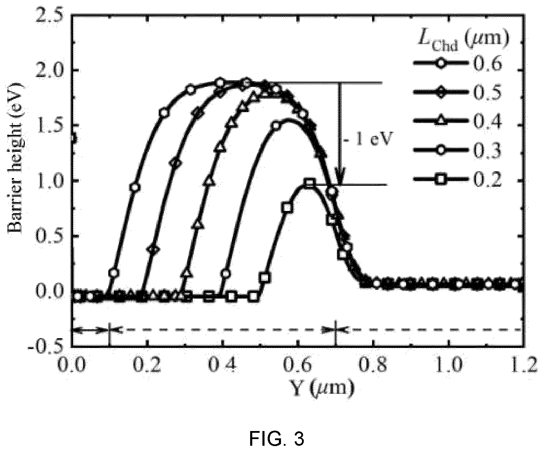

Specifically, as shown in FIG. 3, which show variation curves of the barrier height of the MOS channel diode in the structure in FIG. 1 for several different channel lengths. In the device, the substrate 11 has a doping concentration of 1.0 × 1019 cm-3 and a thickness of 2 µm; the drift region 121 has a doping concentration of 8.0 × 1015 cm-3 and a thickness of 10 µm; the current transport layer 122 has a doping concentration of 6.0 × 1016 cm-3 and a thickness of 2 µm; each of the electric field shielding layers 18 has a doping concentration of 1.0 × 1019 cm-3 and a thickness of 0.4 µm; the gate dielectric layer and the second dielectric layer 142 each have a thickness of 50 nm; the body region 15 has a doping concentration of 1.4 × 1017 cm-3, a thickness of 0.7 µm and a width of 0.8 µm (the width here refers to the length of the body region 15 between the side wall of the gate structure 13 and the correspond one of the side walls of the source trench structure 14); each of the source regions 151 and the contact regions 152 has a doping concentration of 1.0 × 1019 cm-3, a thickness of 0.2 µm and a width of 0.3 µm; the doped layer 161 of the first conductivity type has a doping concentration of 1.0 × 1019 cm-3, with a thickness and width of 0.2 µm. In FIG. 3, LChd denotes the length of the conductive channel of the MOS channel diode, the horizontal axis Y represents the distance from an upper surface of the doped layer 161 of the first conductivity type extending towards the epitaxial layer 12, where a position of 0 µm corresponds to the upper surface of the doped layer 161 of the first conductivity type, and a position of 0.7 µm corresponds to a lower surface of the body region 15. It can be seen from FIG. 3 that when the length of the conductive channel of the MOS diode decreases from 0.5 µm to 0.2 µm, the barrier height of the electrons decreases by 1 eV, which means that the turn-on voltage of the MOS channel diode decreases by 1 V. Thus, as the length of the conductive channel of the MOS diode decreases, the barrier height of the electrons gradually decreases, and the turn-on voltage of the MOS diode also gradually decreases.

In the present disclosed power MOSFET, one source trench structure 14 is provided between two adjacent gate structures 13, and each of the side walls of the source trench structure 14 is spaced a preset distance apart from the side wall of the correspond one of the gate structures 13 ; the source trench structure 14 comprises the source trench 141, the second dielectric layer 142 and the source conductive layer 143; the upper trench 17 is provided above the source trench structure 14, and each of the side walls of the upper trench 17 extends in a direction towards the corresponding gate structure 13 to a preset distance away from the correspond one of the side walls of the source trench structure 14; the body region 15 is exposed from the bottom of the upper trench 17; and the barrier layer 16 is provided at the bottom of the upper trench 17, so as to form the MOS channel diode consisting of the barrier layer 16, the body region 15, the source trench structure 14 and the current transport layer 122. The length of the conductive channel of the MOS channel diode is reduced by deepening the upper trench 17. Due to the drain-induced barrier lowering effect, the barrier height for electrons to pass through the body region 15 and into the barrier layer 16 is reduced, which in turn reduces the turn-on voltage of the MOS channel diode. Furthermore, since the source conductive layer 143 in the source trench structure 14 is electrically connected to the source 2, when the device is reversely turned on, the source conductive layer 143 is connected to a high voltage, causing the conductive channel between the source trench structure 14 and the body region 15 to turn on. As a result, the device transports the reverse current through the MOS channel diode, reducing the current flowing through the body region 15, thereby suppressing the turn-on of the body diode formed by the body region 15 and the current transport layer 122, and eliminating bipolar degradation of the device.

### Embodiment 2

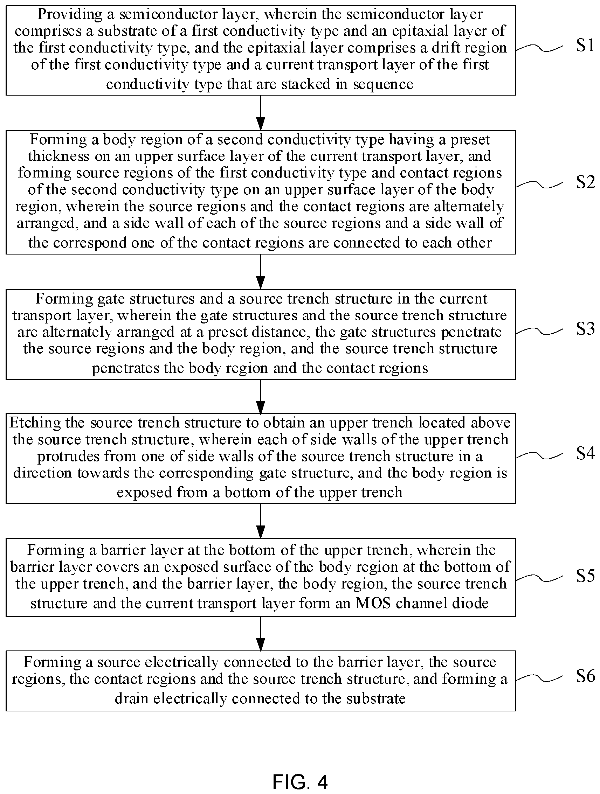

The present embodiment provides a preparation method for a power MOSFET, as shown in FIG. 4. FIG. 4 is a process flowchart of the preparation method, comprising the following steps S1-S6.

Step S1 comprises providing a semiconductor layer, wherein the semiconductor layer comprises a substrate of a first conductivity type and an epitaxial layer of the first conductivity type, and the epitaxial layer comprises a drift region of the first conductivity type and a current transport layer of the first conductivity type that are stacked in sequence.

Step S2 comprises forming a body region of a second conductivity type having a preset thickness on an upper surface layer of the current transport layer, and forming source regions of the first conductivity type and contact regions of the second conductivity type on an upper surface layer of the body region, wherein the source regions and the contact regions are alternately arranged, and a side wall of each of the source regions and a side wall of the correspond one of the contact regions are connected to each other.

Step S3 comprises forming gate structures and a source trench structure in the current transport layer, wherein the gate structures and the source trench structure are alternately arranged at a preset distance, the gate structures penetrate the source regions and the body region, and the source trench structure penetrates the body region and the contact regions.

Step S4 comprises etching the source trench structure to obtain an upper trench located above the source trench structure, wherein each of side walls of the upper trench protrudes from one of side walls of the source trench structure in a direction towards the corresponding gate structure, and the body region is exposed from a bottom of the upper trench.

Step S5 comprises forming a barrier layer at the bottom of the upper trench, wherein the barrier layer covers an exposed surface of the body region at the bottom of the upper trench, and the barrier layer, the body region, the source trench structure and the current transport layer form an MOS channel diode.

Step S6 comprises forming a source electrically connected to the barrier layer, the source regions, the contact regions and the source trench structure, and forming a drain electrically connected to the substrate.

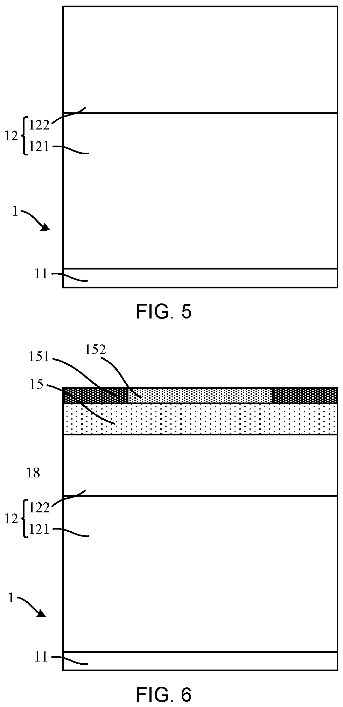

In step S1 and step S2, as shown in FIGS. 5-6, a semiconductor structure 1 comprising a substrate 11 of a first conductivity type and an epitaxial layer 12 of the first conductivity type is provided, the epitaxial layer 12 comprises a drift region 121 of the first conductivity type and a current transport layer 122 of the first conductivity type that are stacked in sequence; a body region 15 of a second conductivity type having a preset thickness is formed on an upper surface layer of the current transport layer 122, and a plurality of source regions 151 of the first conductivity type and a plurality of contact regions 152 of a second conductivity type are formed on an upper surface layer of the body region 15; the source regions 151 and the contact regions 152 are alternately provided, and a side wall of each of the source regions 151 and a side wall of the correspond one of the contact regions 152 are adjacent to each other.

Specifically, as shown in FIG. 5, which is a schematic diagram of the cross-sectional structure of the semiconductor structure 1, in the case where the performance of the device is guaranteed, the thickness and the doping concentration of the substrate 11 may be set according to the actual situation. In the present embodiment, the substrate 11 has a doping concentration of 1.0 × 1019 cm-3 and a thickness of 2 µm.

Specifically, in the case where the performance of the device is guaranteed, the thickness and the doping concentration of the drift region 121 may be set according to the actual situation. In the present embodiment, the drift region 121 has a doping concentration of 8.0 × 1015 cm-3 and a thickness of 10 µm.

Specifically, in the case where the performance of the device is guaranteed, the thickness and the doping concentration of the current transport layer 122 may be set according to the actual situation. In the present embodiment, the current transport layer 122 has a doping concentration of 6.0 × 1016 cm-3 and a thickness of 2 µm.

Specifically, as shown in FIG. 6, which is a schematic diagram of the cross-sectional structure of the power MOSFET after the formation of the body region 15, the source regions 151 and the contact regions 152, methods of forming the body region 15 comprise ion implantation, or other suitable methods.

Specifically, methods of forming the source regions 151 comprise ion implantation or other suitable methods.

Specifically, methods of forming the contact regions 152 comprise ion implantation or other suitable methods.

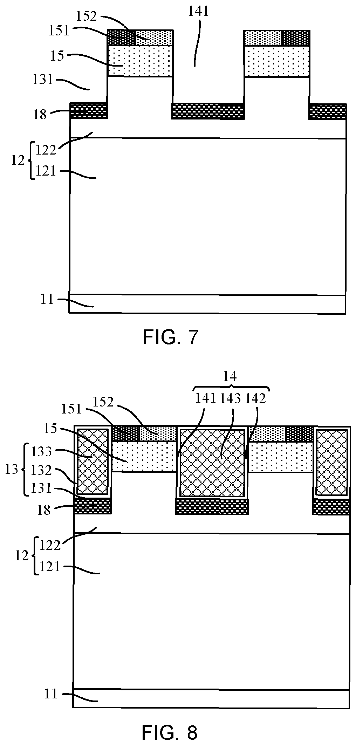

In step S3, step S4, and step S5, as shown in FIGS. 7-10, a plurality of gate structures 13 and a source trench structure 14 are formed in the current transport layer, the gate structures 13 and the source trench structure 14 are alternately provided at a preset distance, the gate structures 13 penetrate the source regions 151 and the body region 15, and the source trench structure 14 penetrates the body region 15 and the contact regions 152; the source trench structure 14 is etched to obtain an upper trench 17 located above the source trench structure 14, each of side walls of the upper trench 17 protrudes from one of side walls of the source trench structure 14 in a direction towards the corresponding gate structure 13, and the body region 15 is exposed from a bottom of the upper trench 17; a barrier layer 16 is formed at the bottom of the upper trench 17, the barrier layer 16 covers an exposed surface of the body region 15 at the bottom of the upper trench 17, and the barrier layer 16, together with the body region 15, the source trench structure 14 and the current transport layer 122, forms an MOS channel diode.

Specifically, each of the gate structures 13 comprises a gate trench 131, a first dielectric layer 132, and a gate conductive layer 133, and the first dielectric layer 132 is located on inner walls and a bottom face of the gate trench 131 and wraps the gate conductive layer 133.

Specifically, the first dielectric layer 132 comprises a gate dielectric layer located on the inner walls and the bottom face of the gate trench 131, and an interlayer dielectric layer covering upper surfaces of the gate dielectric layer and the gate conductive layer.

Specifically, the source trench structure 14 comprises a source trench 141, a second dielectric layer 142, and a source conductive layer 143, and the second dielectric layer 142 is located on inner walls and a bottom face of the source trench 141 and wraps side walls and a bottom face of the source conductive layer 143.

Specifically, as shown in FIG. 8, which is a schematic diagram of the cross-sectional structure of the power MOSFET after the formation of the gate structures 13, a patterned photoresist layer is formed on an upper surface of the epitaxial layer 12, and the gate trench 131 is formed on the basis of the patterned photoresist layer; the gate dielectric layer is formed on the inner walls and the bottom face of the gate trench 131, and the gate conductive layer 133 is formed to fill the gate trench 131; and the interlayer dielectric layer covering the upper surfaces of the gate dielectric layer and the gate conductive layer 133 is formed on the upper surface of the epitaxial layer 12, so as to obtain the gate structures 13.

Specifically, the source trench 141 can be formed synchronously with the gate trench 131. Alternatively, the source trench 141 can be formed either before or after the gate structures 13. When the source trench 141 is formed before the gate structures 13, the source trench 141, the second dielectric layer 142, and the source conductive layer 143 must be formed before the gate trench 131. In the present embodiment, in order to reduce the number of process steps and save costs, the epitaxial layer 12 is etched to form both the gate trench 131 and the source trench 141 simultaneously.

Specifically, in the case where the performance of the device is guaranteed, the gate dielectric layer and the second dielectric layer 142 may be formed simultaneously, and may also be formed in different steps. In the present embodiment, in order to reduce the number of process steps, the gate dielectric layer and the second dielectric layer 142 are formed simultaneously.

Specifically, the gate conductive layer 133 and the source conductive layer 143 may be formed simultaneously, and may also be formed in different steps. In the present embodiment, the gate conductive layer 133 and the source conductive layer 143 are formed synchronously, to reduce the number of process steps and save costs.

The method of forming the patterned photoresist layer is standard and will not be repeated herein.

Specifically, methods of forming the gate trench 131 comprise dry etching, wet etching, or other suitable etching methods.

Specifically, methods of forming the gate dielectric layer comprise chemical vapor deposition, physical vapor deposition, a thermal oxidation method, or other suitable methods; methods of forming the second dielectric layer 142 comprise chemical vapor deposition, physical vapor deposition, a thermal oxidation method, or other suitable methods.

Specifically, methods of forming the gate conductive layer 133 comprise chemical vapor deposition, physical vapor deposition, or other suitable methods; and methods of forming the source conductive layer 143 comprise chemical vapor deposition, physical vapor deposition, or other suitable methods.

Specifically, the interlayer dielectric layer also covers the upper surface of the epitaxial layer (the source regions and the contact regions).

Specifically, methods of forming the interlayer dielectric layer comprise chemical vapor deposition, physical vapor deposition, or other suitable methods.

Specifically, methods of forming the source trench 141 comprise dry etching, wet etching, or other suitable etching methods.

Specifically, as shown in FIG. 7, which is a schematic diagram of the cross-sectional structure of the power MOSFET after the formation of the electric field shielding layers 18, after forming the gate trench 131 and the source trench 141 and before forming the first dielectric layer 132 and the second dielectric layer 142, the preparation method further comprises forming electric field shielding layers 18 of the second conductivity type in the current transport layer 122 directly under bottom faces of the gate trench 131 and the source trench 141.

Specifically, methods of forming the electric field shielding layers 18 comprise ion implantation or other suitable methods.

Specifically, methods of forming the upper trench 17 comprise dry etching, wet etching, or other suitable etching methods.

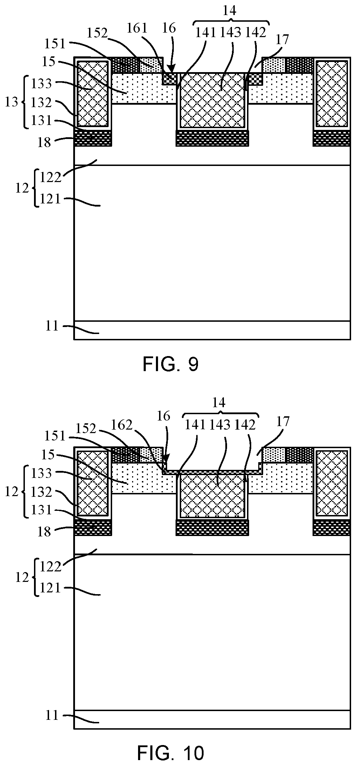

Specifically, as shown in FIGS. 9 and 10, which respectively depict a schematic diagram of one cross-sectional structure of the power MOSFET after the formation of the barrier layer 16 and a schematic diagram of another cross-sectional structure of the power MOSFET after the formation of the barrier layer 16, the barrier layer 16 comprises a doped layer 161 of the first conductivity type and a metal barrier contact layer 162.

Specifically, when the barrier layer 16 is the doped layer 161 of the first conductivity type, methods of forming the barrier layer 16 comprise ion implantation, chemical vapor deposition, physical vapor deposition, or other suitable methods. In the present embodiment, in order to simplify the process steps, the barrier layer 16 is formed in the body region 15 at the bottom of the upper trench 17 by using an ion implantation method.

Specifically, when the barrier layer 16 is the metal barrier contact layer 162, methods of forming the barrier layer 16 comprise a sputtering method, physical vapor deposition, a chemical vapor deposition, a metal compound vapor deposition, a molecular beam epitaxy method, an atomic vapor deposition, an atomic layer deposition, or other suitable methods.

In step S6, as shown in FIGS. 1 and 2, a source 2 electrically connected to the barrier layer 16, the source regions 151, the contact regions 152 and the source trench structure 14 is formed, and a drain 3 electrically connected to the substrate 11 is formed.

Specifically, methods of forming the source 2 comprise a sputtering method, physical vapor deposition, a chemical vapor deposition, a metal compound vapor deposition, a molecular beam epitaxy method, an atomic vapor deposition, an atomic layer deposition, or other suitable methods.

Specifically, the source 2 fills the upper trench 17, and is electrically connected to the source conductive layer 143 either directly or by means of a conductive material.

Specifically, as shown in FIGS. 1 and 2, which respectively depict a schematic diagram of one cross-sectional structure of the power MOSFET after the formation of the drain 3 and a schematic diagram of another cross-sectional structure of the power MOSFET after the formation of the drain 3, methods of forming the drain 3 comprise a sputtering method, physical vapor deposition, a chemical vapor deposition, a metal compound vapor deposition, a molecular beam epitaxy method, an atomic vapor deposition, an atomic layer deposition, or other suitable methods.

Specifically, the source trench 141, the second dielectric layer 142, and the source conductive layer 143 can be formed synchronously with the gate trench 131, the gate dielectric layer, and the gate conductive layer 133, only the steps of forming the upper trench 17 and forming the barrier layer 16 are added with respect to the process of forming a double-channel MOSFET, and the processes of forming the upper trench 17 and the barrier layer 16 are simple.

Specifically, due to the formation of the upper trench 17, the barrier layer 16 and the source trench structure 14, the MOS channel diode is formed in the device, with the length of the conductive channel controlled by the depth of the upper trench 17, reducing the barrier height between the barrier layer 16 and the body region 15 in the device, and lowering the turn-on voltage of the MOS channel diode and the conduction loss of the device; meanwhile, when the device is reversely turned on, the source conductive layer 143 is electrically connected to the source 2, causing the conductive channel in the body region 15 adjacent to the source trench structure 14 to be opened, enabling the reverse current to be transported through the conductive channel, thereby suppressing the turn-on of the body diode in the device while enhancing the reverse current conduction capability of the device; additionally, the preparation process is simple.

In the present disclosed preparation method for the power MOSFET, the upper trench 17 of a preset depth is formed above the source trench structure 14, the barrier layer 16 covering the body region 15 is formed in the upper trench 17, one MOS channel diode is formed by using the barrier layer 16, the body region 15, the source trench structure 14 and the current transport layer 122, and the length of the conductive channel in the MOS channel diode is reduced by increasing the depth of the upper trench 17, reducing the turn-on voltage of the MOS channel diode and the conduction loss of the device; moreover, there is no need to add complex process steps, and the preparation method is simple.

In summary, for the present disclosed power MOSFET and its preparation method,, the source trench structure is provided between two adjacent gate structures at a preset distance, the upper trench is provided above the source trench structure, each of the side walls of the upper trench extends in a direction towards the corresponding gate structure to a preset distance away from the correspond one of the side walls of the source trench structure, and the barrier layer is formed at the bottom of the upper trench, so as to obtain the MOS channel diode consisting of the barrier layer, the body region, the current transport layer and the source trench structure. The length of the conductive channel of the MOS channel diode is controlled through the depth of the upper trench, and the barrier height for electrons to pass through the body region and into the barrier layer is reduced by lowering the length of the conductive channel of the MOS channel diode, so as to reduce the turn-on voltage of the MOS channel diode and reduce the conduction loss of the device. When the device is reversely turned on, the source is electrically connected to the source conductive layer, causing the conductive channel in the body region near the source trench structure to be opened, and enabling the reverse current in the device to be transported through the conductive channel of the MOS channel diode. By means of reduction in the reverse current in the body region, the turn-on of the body diode in the device is inhibited, thereby eliminating bipolar degradation, and improving the reverse current transport capability of the device. Moreover, the process of forming the source trench, the second dielectric layer and the source conductive layer is performed synchronously with the process of forming the gate structure, the process of forming the upper trench and the barrier layer is simple, no complex process is required, and the process steps are simple. Therefore, the present invention effectively overcomes various shortcomings in the prior art and has high industrial utilization value.

The above-described examples are merely illustrative of the principles and efficacy of the present invention and are not intended to limit the present invention. Anyone skilled in the art can make modifications or changes to the above-described embodiments without departing from the spirit and scope of the present invention. Accordingly, all equivalent modifications or changes made by those of ordinary knowledge in the art without departing from the spirit and technical ideas disclosed herein should still be covered by the claims of the present invention.

## Claims

1. A power MOSFET, comprising:
a semiconductor structure, comprising a substrate of a first conductivity type and an epitaxial layer of the first conductivity type that are stacked in sequence, wherein the epitaxial layer comprises a drift region of the first conductivity type and a current transport layer of the first conductivity type that are stacked in sequence;
gate structures, provided at intervals and embedded in the current transport layer;
a source trench structure, located between two adjacent gate structures, wherein each of side walls of the source trench structure is spaced apart from a side wall of a corresponding gate structure by a preset distance, an upper trench of a preset depth is provided above the source trench structure, and each of side walls of the upper trench protrudes from one of the side walls of the source trench structure in a direction towards the corresponding gate structure;
a body region of a second conductivity type, located on an upper surface layer of the current transport layer between each of the gate structures and the source trench structure, wherein the body region is exposed from a bottom of the upper trench;
source regions of the first conductivity type and contact regions of the second conductivity type, wherein the source regions and the contact regions are both located on an upper surface layer of the body region, one of the source regions and the correspond one of the contact regions located between the gate structure and the upper trench are adjacent to each other, and a side wall of said source region away from said contact region is adjacent to the side wall of the corresponding gate structure;
a barrier layer, located at the bottom of the upper trench and configured to cover an exposed surface of the body region at the bottom of the upper trench, wherein the barrier layer, the body region, the source trench structure, and the current transport layer form an MOS channel diode; and
a source and a drain, wherein the source is electrically connected to the barrier layer, the source regions, the contact regions, and the source trench structure, and the drain is electrically connected to the substrate.

2. The power MOSFET according to claim 1, wherein each of the gate structures comprises a gate trench, a first dielectric layer and a gate conductive layer, the first dielectric layer is located on inner walls and a bottom face of the gate trench and wraps the gate conductive layer; wherein the source trench structure comprises a source trench, a second dielectric layer and a source conductive layer, the second dielectric layer is located on inner walls and a bottom face of the source trench and wraps side walls and a bottom face of the source conductive layer.

3. The power MOSFET according to claim 1, wherein electric field shielding layers of the second conductivity type are provided in the current transport layer directly under the gate structures and the source trench structure, wherein a lower surface of each of the electric field shielding layers is spaced apart from a bottom face of the current transport layer by a preset distance, and an upper surface of each of the electric field shielding layers is in contact with a lower surface of the correspond one of the gate structures and the source trench structure, wherein two adjacent electric field shielding layers are arranged spaced apart from each other.

4. The power MOSFET according to claim 3, wherein a doping concentration of the electric field shielding layers is greater than a doping concentration of the current transport layer.

5. The power MOSFET according to claim 1, wherein a length of a conductive channel of the MOS channel diode is adjusted through the depth of the upper trench.

6. The power MOSFET according to claim 1, wherein the barrier layer comprises one of a doped layer of the first conductivity type and a metal barrier contact layer.

7. The power MOSFET according to claim 6, wherein the barrier layer is the metal barrier contact layer, and a bottom face of the upper trench is lower than lower surfaces of the contact regions.

8. The power MOSFET according to claim 7, wherein the barrier layer covers an exposed surface of the source trench structure at the bottom of the upper trench.

9. The power MOSFET according to claim 7, wherein the metal barrier contact layer is not electrically connected to the source trench structure.

10. The power MOSFET according to claim 6, wherein the barrier layer is the doped layer of the first conductivity type, a lower surface of the barrier layer is lower than lower surfaces of the contact regions and is spaced apart from a bottom face of the body region by a preset distance, and each of side walls of the barrier layer is adjacent to the correspond one of the side walls of the source trench structure.

11. The power MOSFET according to claim 10, wherein a doping concentration of the barrier layer is higher than a doping concentration of the current transport layer.

12. A preparation method for a power MOSFET, comprising:
providing a semiconductor layer, wherein the semiconductor layer comprises a substrate of a first conductivity type and an epitaxial layer of the first conductivity type, and the epitaxial layer comprises a drift region of the first conductivity type and a current transport layer of the first conductivity type that are stacked in sequence;
forming a body region of a second conductivity type having a preset thickness on an upper surface layer of the current transport layer, and forming source regions of the first conductivity type and contact regions of the second conductivity type on an upper surface layer of the body region, wherein the source regions and the contact regions are alternately arranged, and a side wall of each of the source regions and a side wall of the correspond one of the contact regions are adjacent to each other;
forming gate structures and a source trench structure in the current transport layer, wherein the gate structures and the source trench structure are alternately arranged at a preset distance, the gate structures penetrate the source regions and the body region, and the source trench structure penetrates the body region and the contact regions;
etching the source trench structure to obtain an upper trench located above the source trench structure, wherein each of side walls of the upper trench protrudes from one of side walls of the source trench structure in a direction towards the corresponding gate structure, and the body region is exposed from a bottom of the upper trench;
forming a barrier layer at the bottom of the upper trench, wherein the barrier layer covers an exposed surface of the body region at the bottom of the upper trench, and the barrier layer, the body region, the source trench structure and the current transport layer form an MOS channel diode; and
forming a source electrically connected to the barrier layer, the source regions, the contact regions and the source trench structure, and forming a drain electrically connected to the substrate.

13. The preparation method according to claim 12, wherein each of the gate structures comprises a gate trench, a first dielectric layer and a gate conductive layer, the first dielectric layer is located on inner walls and a bottom face of the gate trench and wraps the gate conductive layer; wherein the source trench structure comprises a source trench, a second dielectric layer and a source conductive layer, the second dielectric layer is located on inner walls and a bottom face of the source trench and wraps side walls and a bottom face of the source conductive layer.

14. The preparation method according to claim 13, wherein after forming the gate trench and the source trench and before forming the first dielectric layer and the second dielectric layer, the preparation method further comprises forming electric field shielding layers of the second conductivity type in the current transport layer directly under bottom faces of the gate trench and the source trench.

15. The preparation method according to claim 12, wherein the barrier layer comprises one of a doped layer of the first conductivity type and a metal barrier contact layer.
